Europäisches Patentamt

European Patent Office

Office européen des brevets

(11) Numéro de publication: **0 375 507**
**A1**

## (12) DEMANDE DE BREVET EUROPEEN

(21) Numéro de dépôt: **89403440.4**

(51) Int. Cl.5: **H03H 9/38**

(22) Date de dépôt: **12.12.89**

(30) Priorité: **20.12.88 FR 8816812**

(43) Date de publication de la demande:
**27.06.90 Bulletin 90/26**

(84) Etats contractants désignés:
**DE GB**

(71) Demandeur: **THOMSON-CSF**
**51, Esplanade du Général de Gaulle**
**F-92800 Puteaux(FR)**

(72) Inventeur: **Huignard, Jean-Pierre**
**THOMSON-CSF SCPI Cédex 67**
**F-92045 Paris la Défense(FR)**
Inventeur: **Defranould, Philippe**
**THOMSON-CSF SCPI Cédex 67**
**F-92045 Paris la Défense(FR)**

(74) Mandataire: **Grynwald, Albert et al**
**THOMSON-CSF SCPI**
**F-92045 PARIS LA DEFENSE CEDEX 67(FR)**

(54) **Dispositif à retard d'un signal de fréquence, et système appliquant ce dispositif.**

(57) Dispositif à retard d'un signal de fréquence comprenant un élément en matériau acousto-optique (1) muni d'un premier transducteur piézoélectrique (T1) émettant un signal acoustique dans l'élément (1) et d'un deuxième transducteur piézoélectrique (T2) capable de détecter une onde acoustique. Un faisceau limineux F0 traverse l'élément (1) et crée un champ de charge (12) dans l'élément (1).

Ce champ de charge joue le rôle de réflecteur pour l'onde acoustique émise par le transducteur (T1). En translatant le faisceau (F0) selon la direction Z on fait varier le temps de propagation de l'onde acoustique émise.

APPLICATIONS : Ligne à retard hyperfréquence

FIG_5

# DISPOSITIF A RETARD D'UN SIGNAL DE FREQUENCE ET SYSTEME APPLIQUANT CE DISPOSITIF

L'invention concerne un dispositif retard d'un signal de fréquence et notamment un dispositif de ligne à retard pour signal hyperfréquence ainsi qu'un système appliquant ce dispositif.

Plus particulièrement, l'invention concerne un dispositif de ligne à retard acoustique continûment variable par commande électronique.

Les applications principales se situent dans le traitement des signaux radar large bande pour la commande du balayage d'une antenne électronique.

En effet, cette commande se fait en agissant sur les retards des différents éléments de l'antenne.

Dans les dispositifs connus, ces retards sont engendrés par des lignes coaxiales ou des guides d'ondes (tels que triplaques) associés a des dispositifs de commutation. Cependant de tels dispositifs sont encombrants et volumineux.

La demande de brevet français n° 87 05267 décrit un système permettant de générer des retards, pour des signaux hyperfréquences, a l'aide de moyens optiques. Ces moyens permettent de fabriquer un signal hyperfréquence par battement de deux ondes lumineuses. On dispose de plusieurs trajets lumineux permettant chacun de commander un élément d'antenne. Les différents trajets ont des longueurs différentes ce qui permet de générer les retards relatifs des commandes des différents éléments d'antenne.

Cependant, un tel système ne permet pas de générer des retards continûment variables.

L'invention concerne un dispositif permettant de faire varier le retard d'un signal hyperfréquence de façon continûment variable.

L'invention concerne donc un dispositif à retard d'un signal de fréquence caractérisé en ce qu' il comporte :
- un élément en matériau acousto-optique comportant une première face et une deuxième face faisant un angle entre-elles ;
- au moins un premier transducteur piézoélectrique disposé sur la première face, émettant un signal acoustique dans l'élément selon une première direction et détectant tout signal acoustique arrivant sur la première face ;
- au moins une source lumineuse émettant un faisceau lumineux vers la deuxième face de l'élément, ce faisceau lumineux traversant l'élément selon la deuxième direction sensiblement perpendiculaire à la première direction et créant un champ de charge dans l'élément selon cette deuxième direction.

L'invention concerne également un système appliquant le dispositif à retard caractérisé en ce qu'il comporte, entre la source lumineuse et l'élément en matériau acousto-optique, un déflecteur optique.

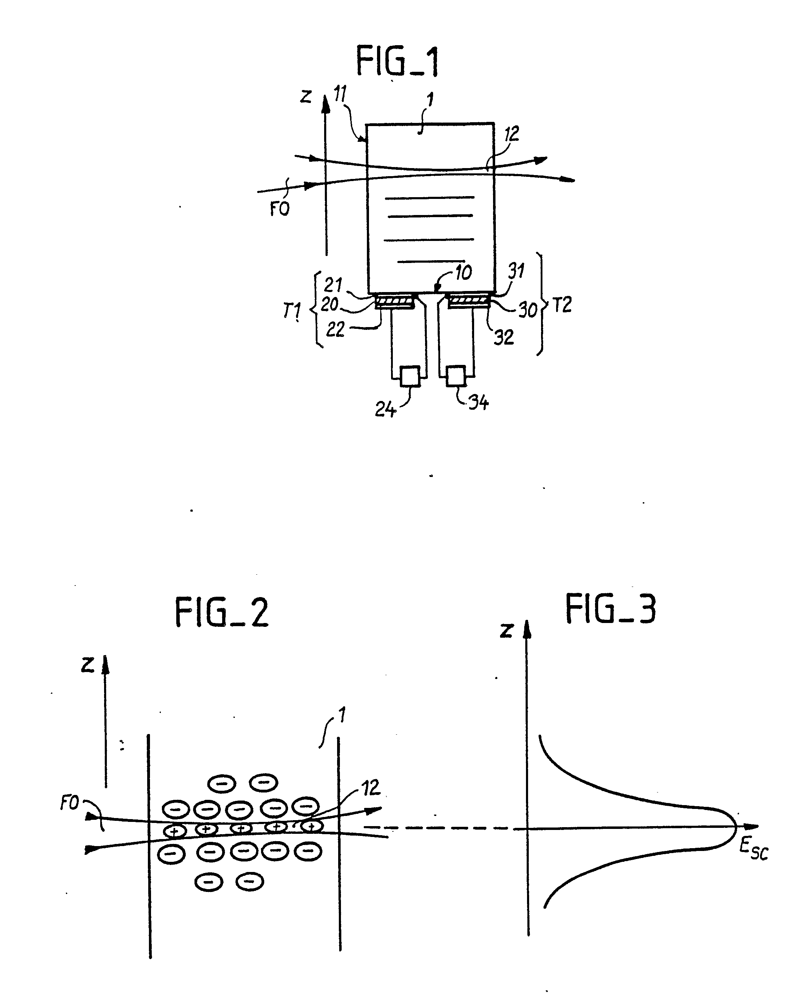

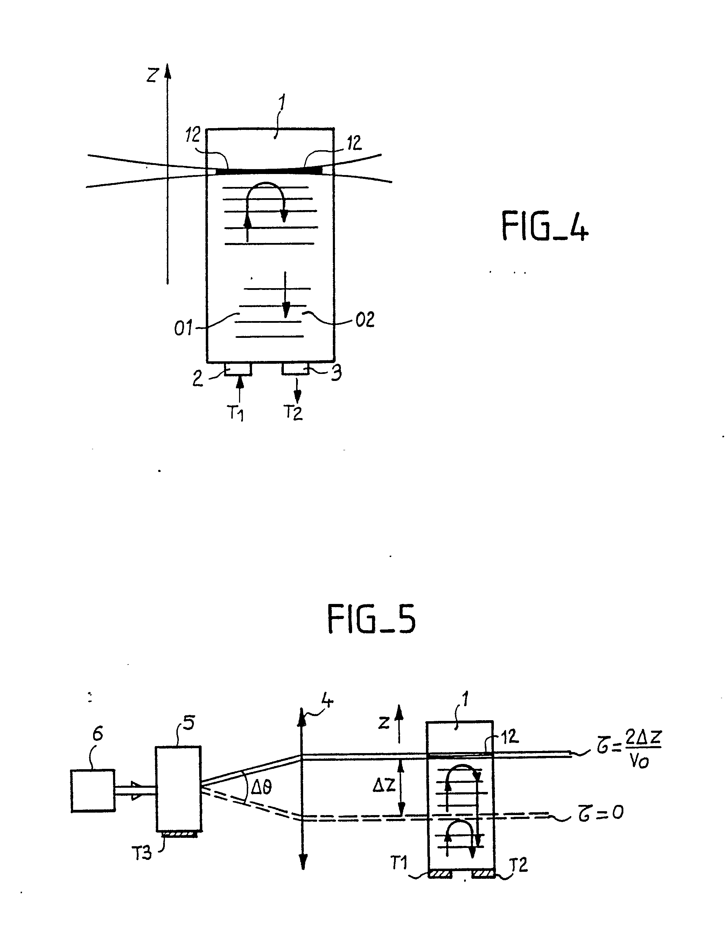

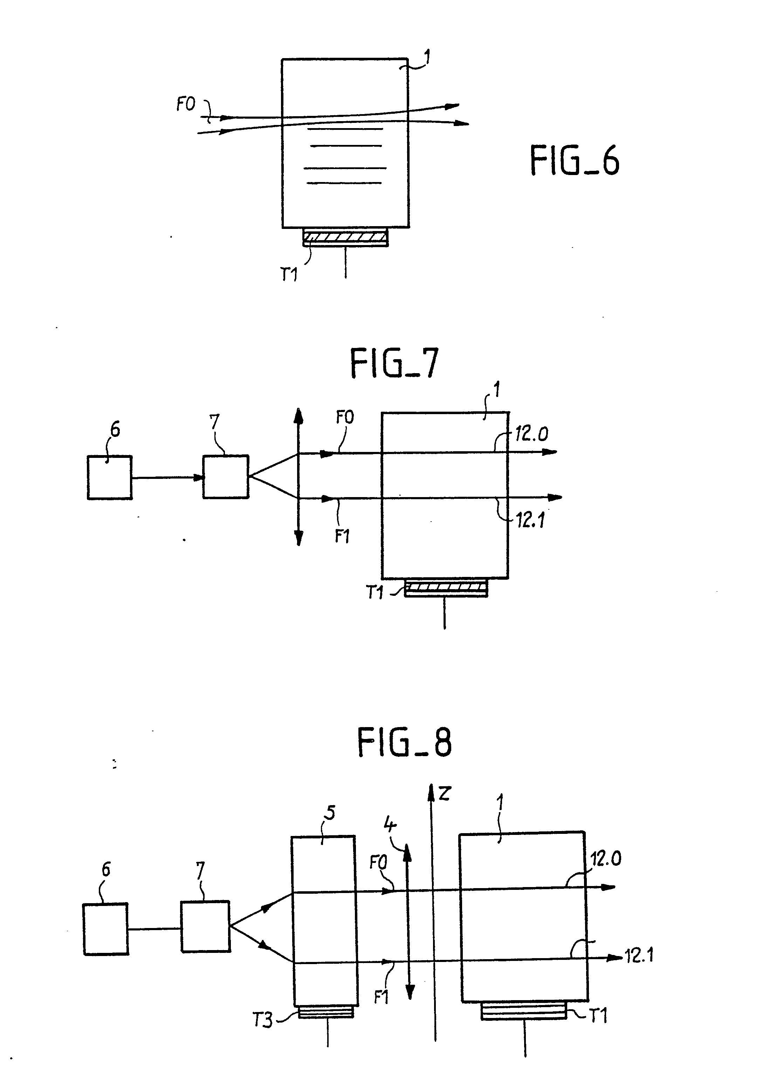

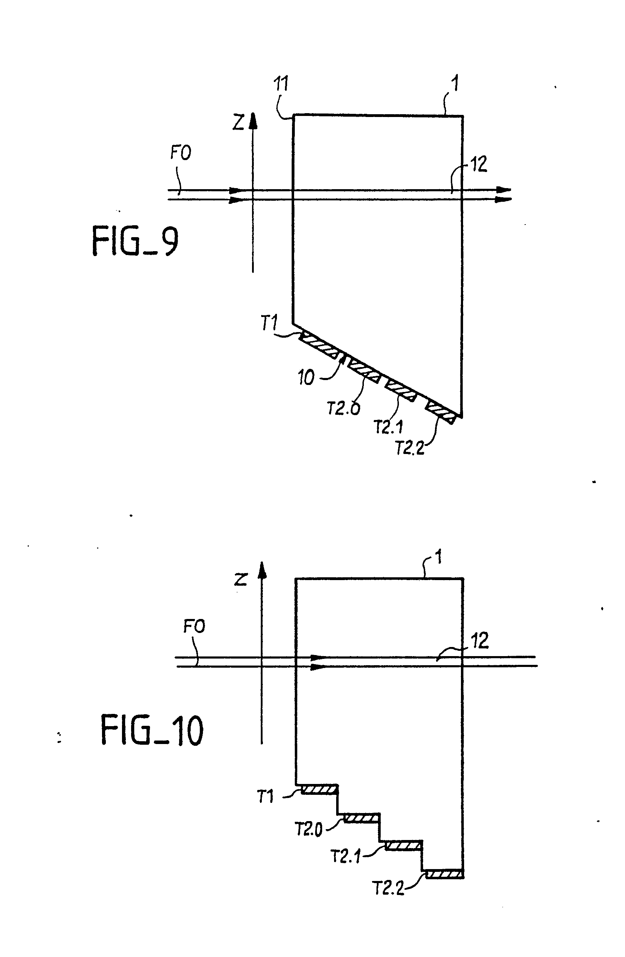

Les différents objets et caractéristiques de l'invention apparaîtront plus clairement dans la description qui va suivre faite en se reportant aux figures annexées qui représentent : - la figure 1, un exemple de réalisation du dispositif à retard selon l'invention ; - les figures 2 à 4, des figures explicatives du dispositif de la figure 1 ; - la figure 5, un exemple de réalisation plus complet du dispositif de l'invention ; - la figure 6, une variante du dispositif de l'invention ; - les figures 7 et 8, une variante du dispositif de la figure 5 ; - les figures 9 et 10, un dispositif selon l'invention comportant plusieurs transducteurs piézoélectriques récepteurs.

En se reportant à la figure 1, on va tout d'abord décrire un dispositif à retard d'un signal hyperfréquence selon l'invention.

Ce dispositif comporte un élément 1 en matériau acousto-optique. Cet élément est muni sur une de ses faces 10 d'un transducteur T1 émetteur d'une onde acoustique et d'un transducteur T2 détecteur d'onde acoustique.

Chaque transducteur est constitué d'un matériau piézoélectrique encadré de deux électrodes. Le transducteur T1 est ainsi constitué d'un élément piézoélectrique 20 enserré entre deux électrodes 21 et 22 permettant de lui appliquer des impulsions d'excitation électriques à l'aide de la connexion 23 et d'un générateur 24.

L'électrode 21 est en contact avec la face 10 ce qui permet au transducteur T1 d'induire des ondes acoustiques dans l'élément 1.

Le transducteur T2 est constitué d'un élément piézoélectrique 30 enserré entre deux électrodes 31 et 32 connectées à un dispositif de détection électrique 34. L'électrode 31 est en contact avec la face 10 et permet au transducteur T2 de détecter une onde acoustique arrivant sur la face 10.

De plus, la face 11 de l'élément 1 reçoit un faisceau lumineux F0 qui traverse l'élément. Selon l'exemple de réalisation de la figure 1, le faisceau F0 est sensiblement perpendiculaire à la direction de propagation de l'onde acoustique émise par le transducteur T1.

Par ailleurs, des moyens non représentés sur la figure 1 permettent de déplacer le faisceau F0 parallèlement à sa direction de façon que l'éclairement de l'élément soit déplacé selon la direction Z.

Le dispositif proposé repose sur l'utilisation des deux effets suivants :
- génération dans le volume du matériau acoustique 1 d'un champ de charge d'espace qui modifie localement la vitesse de l'onde acoustique ;

- réflexion de l'onde acoustique de volume sur la zone de charge d'espace 12 photoinduite dans le matériau 1. La position de cette zone est contrôlée par l'intermédiaire d'un faisceau laser F0.

Pour obtenir la génération d'un miroir acoustique photoinduit, le matériau 1 utilisé est donc un matériau permettant la propagation d'ondes acoustiques et le milieu de propagation possède également des propriétés optiques non linéaires. A titre d'exemple, ce matériau pourra être l'un des matériau suivants :

LiNbO₃, BSO, BGO, GaAs, InP...

De ce fait il est possible d'induire sous illumination locale par un faisceau laser un champ de charge d'espace susceptible de modifier, la fois l'indice optique et acoustique du milieu. Le champ de charge est représenté sur la figure 2 et on constate qu'un maximum de charge représenté par la courbe de la figure 3 est localisé dans la zone 12.

Les mécanismes physiques mis en jeu peuvent être décrits de la façon suivante : le milieu de propagation de l'onde acoustique étant éclairé par un faisceau laser focalisé, les photoporteurs générés et repiégés dans la région périphérique du faisceau créent une zone de charge d'espace qui est une réplique de l'illumination incidente. La modulation de champ électrique correspondant à la charge d'espace photoinduite induit une réflexion élémentaire de l'onde acoustique avec un coefficient de réflexion R donné par la relation :

$$\Delta R = 1/2 [K + d]\Delta E_{sc}$$

où K et d sont respectivement, le coefficient électro-acoustique et le coefficient piézoélectrique du milieu 1. $\Delta E_{sc}$ est la variation du champ de charge d'espace. Les évaluations théoriques relatives LiNbO₃ montrent par exemple que pour un champ électrique photoinduit de $\Delta E_{sc} = 10\text{-}50$ kV. cm¹ le coefficient de réflexion élémentaire de l'onde acoustique sur cette zone de charge d'espace localisée peut être estimé à $\Delta R = 10^{-4}$ à $10^3$ (effet acousto- photoréfractif).

Le transducteur T1 émet une onde acoustique 01 et selon le schéma du dispositif indiqué sur la figure 4, l'onde 02 acoustique réfléchie est détectée soit par le transducteur émetteur T1 lui-même, soit par le transducteur T2.

Selon la position du faisceau F0 par rapport à la face 10 de l'élément, le temps mis par l'onde acoustique émise par le transducteur T1 pour atteindre la zone de charge d'espace 12, puis être réfléchi et atteindre ensuite le transducteur T2 est plus ou moins long. En déplaçant le faisceau F0 selon la direction Z, on modifie la longueur du trajet de l'onde acoustique et donc son temps de propagation. On réalise donc un dispositif à retard continûment variable.

La figure 5 représente un système permettant de déplacer le faisceau F0 selon la direction 2 de façon réaliser un retard continûment variable entre $t = 0$ et $T = \tau$ sur le signal acoustique.

Ce système comporte le dispositif de la figure 1, c'est-à-dire l'élément 1 muni sur sa face 10 de transducteurs piézoélectriques T1 et T2 avec sa face 11 éclairée par le faisceau lumineux F0. Le faisceau lumineux F0 est fourni par une source lumineuse 6 (source laser).

Entre la source 6 et la face 11 de l'élément 1 sont disposés sur le trajet du faisceau lumineux F0 :

- un déflecteur optique 5
- une lentille de focalisation 4

A titre d'exemple, le déflecteur 5 est réalisé sous la forme d'un déflecteur acousto-optique (cellule de Bragg). Il comporte un élément déflecteur 5 en matériau acousto-optique, du même type que celui de l'élément 1, possédant un transducteur piézoélectrique T3. Le transducteur T3 est du même type que les transducteurs T1 et T2. Le transducteur T3 permet ainsi de générer des ondes acoustiques dans le déflecteur 5 et d'induire un réseau d'indice qui permet de défléchir le faisceau F0 fourni par la source 6.

La fréquence du signal d'excitation du transducteur détermine le pas du réseau d'indice qui détermine, lui-même, l'angle de déflexion du faisceau F0.

Le déflecteur 5 est placé dans le plan focal de la lentille de focalisation 4. Celle - ci retransmet le faisceau reçu du déflecteur 5 selon une direction parallèle l'axe optique de la lentille 4.

La combinaison du déflecteur 5 et de la lentille 4 permet ainsi de déplacer le faisceau F0 parallèlement a lui-même selon la direction Z.

On voit donc que le dispositif de la figure 5 permet par déflexion du faisceau issu de la source 6, de translater le faisceau F0 selon l'axe Z et donc de modifier le retard apporté à la transmission du signal reçu sur le transducteur T1 et retransmis sur le transducteur T2.

En effet, selon la fréquence du signal hyperfréquence appliqué sur le transducteur piézoélectrique T3 du déflecteur, la position spatiale $\Delta z$ de la zone de charge d'espace dans l'élément 1, varie suivant la relation :

$$\Delta_z = f. \lambda/v_s \Delta F$$

f = focale de la lentille 4

$v_s$ = vitesse de l'onde sonore dans la cellule de déflexion 5

$\Delta F$ = bande passante de la cellule de déflexion 5

$\lambda$ = longueur d'onde lumineuse

Dans ces conditions, le contrôle de la position spatiale du "miroir acoustique photoinduit" 12 introduit sur l'onde acoustique de volume générée par le transducteur T1 un retard tel que

$$\tau = 2 \Delta z/v$$

$v_0$ : vitesse de l'onde acoustique dans le milieu de propagation.

Le dispositif de l'invention est donc commandé par la déflexion d'un faisceau laser induisant une variation locale de réflectivité de l'onde acoustique se propageant dans le volume ou en surface du matériau d'interaction.

Selon une variante de réalisation représentée en figure 6, l'élément 1 ne comporte qu'un seul transducteur piézoélectrique T1 fonctionnant alternativement en émetteur d'onde acoustique et en détecteur d'onde acoustique.

Selon une autre variante, l'élément 1 peut recevoir plusieurs faisceaux lumineux créant chacun un plan de charge d'espace. Par exemple sur la figure 7 on a prévu deux faisceaux F0 et F1 obtenus par division du faisceau issu de la source 6 à l'aide d'un séparateur de faisceau 7. Les faisceaux F0 et F1 sont rendus parallèles par un dispositif optique 4 (lentille). On aurait également pu prévoir une source lumineuse par faisceau F0, F1. On peut également prévoir plus de deux faisceaux lumineux.

Les faisceaux F0 et F1 créent des plans de charge d'espace 12.0 et 12.1. Une onde acoustique émise par le transducteur T1 est réfléchie partiellement par le plan de charge d'espace 12.1 et la partie non réfléchie est réfléchie partiellement par le plan de charge 12.0. Le transducteur T1 reçoit donc en retour deux ondes acoustiques ayant subi des retards différents.

Il est bien évident que le dispositif de la figure 7 peut prévoir un transducteur d'émission T1 et un ou plusieurs transducteurs de détection tels que T2 sur la figure 1.

La figure 8 représente une variante du dispositif de la figure 7 dans lequel on prévoit un déflecteur 5 tel que celui de la figure 5. Le déflecteur 5 est placé entre le séparateur de faisceau 7 et l'élément 1. Selon le signal de fréquence appliqué au transducteur T3, le réseau d'indice créé dans le transducteur 5 permet de translater les deux faisceaux F0 et F1 selon la direction Z. Les plans de charge d'espace 12.0 et 12.1 peuvent donc être déplacés selon la direction Z et on peut faire varier les retards affectés aux ondes acoustiques réfléchies vers le transducteur T1.

La figure 9 représente une autre variante du dispositif de l'invention dans laquelle la face 10 de l'élément 1 forme un angle avec la direction du faisceau lumineux F0 et donc forme un angle avec le plan de charge d'espace 12. La face 10 est munie de plusieurs transducteurs piézoélectriques tels qu'un transducteur émetteur T1 et trois transducteurs détecteurs T2.0, T2.1 et T2.3.

Une onde acoustique émise par le transducteur T1 est réfléchie par le plan de charge d'espace 12 et met des temps différents pour atteindre les transducteurs T2.0 à T2.2. Les détections dans les différents transducteurs T2.0 à T2.2 seront donc affectées de retards différents selon les positions des détecteurs sur la face 10.

On obtient ainsi des retards échelonnés fixes. En faisant translater le faisceau F0 selon l'axe Z, on peut en outre associer un réglage continûment variable à ces retards fixes.

La figure 10 représente une variante du dispositif de la figure 9 dans lequel on a réalisé, à la place de la structure de la figure 9, une structure étagée. A chaque étage est aménagé un transducteur T1, T2.0 à T2.2 de façon à ce que chaque transducteur soit sensiblement parallèle au plan de l'onde acoustique émise par le transducteur T1 et de cette onde réfléchie par le plan de charge d'espace 12.

A titre d'exemple le dispositif de l'invention peut avoir les caractéristiques suivantes :

.Elément 1

- Milieu de propagation de l'onde acoustique (élément 1): GaAs

- Vitesse de propagation dans l'élément 1 $v_0 = 5300 \ ms^{-1}$

- Longueur du milieu de l'élément 1 L = 2 cm

- Transducteur : GaAs ou $LiNbO_3$

. ondes de volume longitudinales

- Signal hyperfréquence :

fréquence centrale : 500 MHz

bande passante 500 MHz

- Retard variable : $\tau = 0$ à $\tau \cong 7,5$ microsecondes

. Déflecteur acousto-optique 5 pour l'inscription du champ de charge d'espace dans GaAs à la longueur d'onde $\lambda = 1,06 \ \mu m$.

Cellule de Bragg $TeO_2$

Nombre de points : $N = 10^3$

Déflexion angulaire : $\Delta\theta = 6°$

Rendement > 50 %

Diamètre du faisceau $\emptyset = 2$ mm

Temps d'accès : 5-10 $\mu sec$

. Dimensions du faisceau focalisé pour l'inscription de la zone de charge d'espace :

- Largeur $= \Delta x/N = 20 \ \mu m$

- Hauteur = 1 mm (hauteur de la colonne acoustique)

. Caractéristiques de la lentille cylindrique 4 de focalisation sur le milieu de propagation

focale $F = \Delta x/\Delta\theta$

F = 200 mm

Temps d'inscription de la zone de charge d'espace dans GaAs

$t = 1\mu s$

.Source laser :

Cette valeur de t correspond à une puissance laser incidente sur le milieu photoréfractif égale à $P = 10mW$.

Un dispositif ainsi décrit permet d'obtenir les avantages suivants :
- Réalisation d'un nouveau dispositif acoustique à onde de volume et à retard variable de $\tau = 0$ à $\tau = 10\mu s$ (typiquement)
- Matériaux d'interaction utilisables GaAs, BSO, LiNbO$_3$.
- Onde de volume - domaine de fréquence utilisable : 100 MHz à 3 GHz typiquement.

Le dispositif de l'invention utilise des matériaux électro-optiques tels que décrits dans les documents :
- Photoréfractive materials and their applications -Springer Verlag - de P. Günter et JP Huignard - vol. 61, 1968.
- Holographic grating acoustic devices - APL - Mai 85 - D.E. Oates et al - MIT, Lincoln Laboraties.

Il est bien évident que la description qui précède n'a été faite qu'à titre d'exemple non limitatif et que d'autres variantes peuvent être envisagées sans sortir du cadre de l'invention. Les exemples numériques et la nature des matériaux indiqués n'ont été fournis que pour illustrer la description.

**Revendications**

1. Dispositif à retard d'un signal de fréquence caractérisé en ce qu'il comprend :
- un élément en matériau acousto-optique (1) comportant une première face (10) et une deuxième face (11) faisant un angle entre elles ;
- au moins un premier transducteur piézoélectrique (2) disposé sur la première face (10), émettant un signal acoustique dans l'élément (1) selon une première direction et détectant tout signal acoustique arrivant sur la première face (10) ;
- au moins une source lumineuse (6) émettant un faisceau lumineux (F0) vers la deuxième face (11) de l'élément (1), ce faisceau lumineux traversant l'élément (1) selon une deuxième direction sensiblement perpendiculaire à la première direction et créant un champ de charge (12) dans l'élément selon cette deuxième direction.

2. Dispositif à retard selon la revendication 1, caractérisé en ce qu'il comprend au moins un deuxième transducteur piézoélectrique (3) disposé sur la deuxième face (10) de l'élément (1) et détectant tout signal acoustique, notamment le signal acoustique émis par le premier transducteur (2) et se réfléchissant sur le champ de charge (12).

3. Dispositif à retard selon la revendication 1, caractérisé en ce que la première face (10) et la deuxième face (11) de l'élément (1) sont sensiblement perpendiculaires.

4. Système appliquant le dispositif à retard selon la revendication 1, caractérisé en ce qu'il comporte, entre la source lumineuse (6) et l'élément (1), un déflecteur optique (5).

5. Système à retard selon la revendication 4, caractérisé en ce qu'il comporte, entre le déflecteur optique (5) et l'élément (1), une lentille de focalisation (4).

6. Dispositif à retard selon la revendication 1, caractérisé en que la source lumineuse (6) est une source laser collimatée.

7. Dispositif à retard selon la revendication 1, caractérisé en ce que l'élément (1) est un cristal photoréfractif à variation d'indice.

8. Système à retard selon la revendication 4, caractérisé en ce que le déflecteur optique (5) est une cellule acousto-optique.

9. Dispositif à retard selon la revendication 1, caractérisé en ce qu'il comporte plusieurs sources lumineuses (5.0, 5.1, 5.2) transmettant chacune un faisceau (F0, F1, F2) lumineux à la deuxième face (11) de l'élément (1) créant chacun un champ de charge (12.0, 12.1, 12.2).

10. Dispositif à retard selon la revendication 1, caractérisé en ce qu'il comporte, entre la source lumineuse (6) et l'élément (1) un séparateur de faisceau (7) transmettant à la deuxième face (11) plusieurs faisceaux (F0, F1).

11. Dispositif à retard selon la revendication 10, caractérisé en ce qu'il comporte, entre la source lumineuse (6) et le séparateur faisceau (7), un déflecteur optique (5).

12. Dispositif à retard selon la revendication 1, caractérisé en ce que le premier et le deuxième transducteur piézoélectrique (2, 3) comportent chacun un matériau piézoélectrique enserré entre deux électrodes, le premier transducteur piézoélectrique (2) étant excité par un signal électrique d'une fréquence déterminée appliquée à ses électrodes, et fournissant en échange un signal acoustique à l'élément (1), le deuxième transducteur piézoélectrique (3) recevant un signal acoustique et fournissant en échange, sur ces électrodes, un signal électrique sensiblement de même fréquence que celle du signal appliqué au premier transducteur (2).

13. Dispositif à retard selon la revendication 1, caractérisé en ce que le signal de fréquence est un signal hyperfréquence.

14. Dispositif à retard selon la revendication 1, caractérisé en ce que la face (10) de l'élément (1) est parallèle à la direction du faisceau lumineux (F0).

15. Dispositif à retard selon la revendication 1, caractérisé en ce que la face (10) de l'élément (1) est inclinée par rapport à la direction du faisceau lumineux (F0) et qu'elle comporte plusieurs transducteurs piézoélectriques de détection (T2.0, T2.1, T2.2) répartis selon la pente de la face (10) par rapport au champ de charge (12).

16. Dispositif à retard selon la revendication 1, caractérisé en ce qu'il comporte une structure étagée sur laquelle est répartie une série de transducteurs piéroélectriques (T1, T2.0 à T2.2) permettant d'obtenir une gamme de retards fixes.

# FIG_1

# FIG_2

# FIG_3

FIG_4

FIG_5

$$\mathcal{C} = \frac{2\Delta z}{v_o}$$

$$\mathcal{C} = 0$$

FIG_6

FIG_7

FIG_8

FIG_9

FIG_10

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-3 185 942  (D. MENDHAM) <br> * En entier * <br> --- | 1 | H 03 H    9/38 |
| A | US-A-3 234 488  (I. BEDMINSTER) <br> * En entier * <br> --- | 1 | |
| A | US-A-3 742 375  (O. FARAH) <br> * En entier * <br> --- | 1 | |
| A | US-A-3 463 573  (M. BRIENZA) <br> ----- | 1 | |

DOMAINES TECHNIQUES RECHERCHES (Int. Cl.5)

H 03 H
G 02 F

Le présent rapport a été établi pour toutes les revendications

| Lieu de la recherche | Date d'achèvement de la recherche | Examinateur |
|---|---|---|
| LA HAYE | 21-03-1990 | DECONINCK E.F.V. |